# EUROPEAN PATENT APPLICATION

(11) **EP 4 152 331 A1**
(43) Date of publication of application: **22.03.2023**
(21) Application number: 21197853.1
(22) Date of filing: 20.09.2021
(51) Int. Cl.: G11C 25/00, G11C 19/00, B01L 3/00, F04B 19/00, F04B 43/09

(54) **MICROFLUIDIC DEVICE**

(71) Applicant: Imec VZW, 3001 Leuven (BE)
(72) Inventor: GOUX, Ludovic, 4280 Hannut (BE)
(74) Representative: DenK iP bv

(57) **Abstract**

A microfluidic device comprising: a. a microfluidic channel (1), and b. a first actuator comprising an array of electrodes (3) along the microfluidic channel (1), wherein the first actuator is configured in such a way that, in operation, the first actuator generates a potential wave along the microfluidic channel.

## Description

### Technical field of the invention

The present invention relates to the field of microfluidic devices. More in particular, the present invention relates to a microfluidic device comprising an actuator for translocating charged particles, and to a method for translocating charged particles.

### Background of the invention

3D NAND Flash memory is today the densest storage memory technology. Further scaling mainly takes place by adding more alternating polysilicon/oxide (P/O) layers to the stack. However, industries foresee that the cost-effectiveness of stacking will reach a limit beyond -500 layers. Therefore, novel concepts enabling larger storage memory densities are currently being considered to prepare the post-3D-NAND era.

Colloidal nanofluidic memory is one of these novel concepts. Its principle is to store information using particles that move into and out of microfluidic channels. The diameter of the channels is scalable below 10nm. The information is stored by the order of the particles in a channel. The combination of these aspects would allow reaching larger densities than 3D NAND Flash, that is, in the range >1Tbit/mm².

Mechanisms envisaged to write the information, which comprises moving the particles into and through the channel, are electro-osmosis and dielectrophoresis. Electro-osmosis requires creating an electric double layer by charging the inner sidewalls of the channel while a vertical field would allow to move the mobile layer and pull the fluid. For dielectrophoresis, the speed of the particles also depends on the field frequency and the dielectric constant of the particles.

However, these mechanisms may not provide a sufficiently large writing speed. Some preliminary simulations suggest that a memory device using electro-osmosis or dielectrophoresis to move particles might still compete with Flash memory. Still, the writing speed may be a limiting factor for the channel length and, therefore, further density increase.

Also in the context of other (i.e., non-memory) microfluidic devices, there is a need for fast translocation of particles through microfluidic channels.

There is thus still a need in the art for devices and methods that address at least some of the above problems.

### Summary of the invention

It is an object of the present invention to provide good microfluidic devices and methods for translocating a charged particle in a microfluidic channel.

The above objective is accomplished by a method and apparatus according to the present invention.

It is an advantage of embodiments of the present invention that fast translocation of charged particles may be achieved. It is an advantage of embodiments of the present invention that the translocation may be faster than translocation via other methods in the field, such as via electro-osmosis or dielectrophoresis. It is an advantage of embodiments of the present invention that the microfluidic channel may be long, and, at the same time, the passage time of particles through the microfluidic channel may be short. It is, therefore, a further advantage of embodiments of the present invention that the microfluidic device may be scalable.

It is an advantage of embodiments of the present invention that the required structure and circuitry may be uncomplicated. It is a further advantage of embodiments of the present invention that the microfluidic device may be used in a broad range of applications wherein charged particles are to be moved through a microfluidic channel, e.g., in colloidal nanofluidic memory devices.

In a first aspect, the present invention relates to a microfluidic device comprising: a. a microfluidic channel, and b. a first actuator comprising an array of electrodes along the microfluidic channel, wherein the first actuator is configured to generate a potential wave along the microfluidic channel

Preferably, the first actuator is configured in such a way that, in operation, each electrode of the array sees its voltage changing cyclically according to a period multiplied by a natural number, wherein for at least one electrode (31, 32) the natural number equals 1, and the cyclically changing voltages of adjacent electrodes are out of phase. More preferably, the first actuator is configured in such a way that, in operation, each electrode of the array sees its voltage changing cyclically according to a same period, and the cyclically changing voltages of adjacent electrodes are out of phase.

In a second aspect, the present invention relates to a method for translocating a charged particle along a microfluidic channel in a microfluidic device according to embodiments of the first aspect, comprising providing a device according to embodiments of the first aspect comprising a fluid comprising at least one charged particle, wherein at least part of the fluid is comprised in the microfluidic channel, and generating a potential wave along the microfluidic channel, e.g. by applying a cyclically changing voltage to each electrode of the array according to a period multiplied by a natural number, wherein for at least one electrode (31, 32) (and preferably for all of the electrodes) the natural number equals 1, and in such a way that the cyclically changing voltages of adjacent electrodes are out of phase.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change, and evolution of devices in this field, the present concepts are believed to represent substantial new and novel improvements, including departures from prior practices, resulting in the provision of more efficient, stable, and reliable devices of this nature.

The above and other characteristics, features, and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 is a schematic cross-section of part of a microfluidic device according to embodiments of the present invention.
FIG. 2 is a schematic cross-section of a memory device according to embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third, and the like in the description and the claims, are used for distinguishing between similar elements and not necessarily for describing a sequence, either temporally, spatially, in ranking, or any other manner. It is to be understood that the terms so used are interchangeable under appropriate circumstances and that the embodiments of the invention described herein are capable of operation in other sequences than described or illustrated herein.

Moreover, the terms top, bottom, over, under, and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps, or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures, or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures, and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a microfluidic device comprising: a. a microfluidic channel, and b. a first actuator configured to generate a potential wave along the microfluidic channel. The potential wave has the effect of putting in motion or accelerating the motion of charged particles present in the channel.

Preferably, the first aspect of the present invention relates to a microfluidic device comprising: a. a microfluidic channel, and b. a first actuator comprising an array of electrodes along the microfluidic channel, wherein the first actuator is configured in such a way that, in operation, each electrode of the array sees its voltage changing cyclically according to a period multiplied by a natural number, wherein for at least one electrode the natural number equals 1, and the cyclically changing voltages of adjacent electrodes are out of phase. In the context of the present invention, a natural number is understood to be an integer number of at least 1. The natural number may be different for different electrodes of the array. In other words, the at least one electrode of the array sees its voltage changing cyclically according to a period, and all other electrodes of the array see their voltage changing according to the period multiplied by a natural number that is at least 2. Different electrodes may relate to different natural numbers. In embodiments, the natural number may be selected, for each electrode independently, from an integer of from 1 to 10, preferably of from 1 to 5, more preferably of from 1 to 2. Preferably, each electrode of the array sees its voltage changing cyclically according to a same period, that is, the natural number equals 1 for each electrode of the array.

In operation, as the voltages of adjacent electrodes are out of phase, a voltage difference is generated between the adjacent electrodes at least part of the time. Hence, at least part of the time, an electric field is generated between the adjacent electrodes in a direction from a first end (e.g., inlet) to a second end (e.g. outlet) of the microfluidic channel. Thereby, in operation, the cyclically changing voltage of each electrode may electrophoretically induce and/or accelerate a translocation of a charged particle in the microfluidic channel between the adjacent electrodes. The translocation may be in a direction from a first end (e.g. inlet) to a second end (e.g. outlet) of the microfluidic channel, or from the second end to the first end. In embodiments, when the device of the first aspect is a memory device, the direction from the first end to the second end can be the write direction and the direction from the second end to the first end can be the read direction. For subsequent voltage change periods of the electrodes, the translocation is typically in the same direction.

In embodiments, the microfluidic channel has a width, in a direction perpendicular to a direction from a first end to a second end, of at most 100 nm, preferably at most 20 nm. For instance, the microfluidic channel may have a width of from 1 to 20 nm. In embodiments, the microfluidic channel has a length, from a first end to a second end, of from 100 nm to 100 µm. In embodiments, the microfluidic channel has an aspect ratio, i.e., a ratio of the length, from a first end to a second end, to the width, in a direction perpendicular to a direction from a first end to a second end, of from 100 to 10000. The electrodes of the array are along the microfluidic channel. In other words, subsequent electrodes within the array occupy subsequent positions along the length of the microfluidic channel. In embodiments, each electrode of the array has an extent measured along the length of the microfluidic channel of from 1 nm to 20 nm, preferably from 3 to 10 nm. In embodiments, the electrodes of the array comprise, e.g., consist of, metal or polycrystalline silicon.

In embodiments, a plurality of microfluidic channels are present, each coupled to a same or different first actuator. In the case of memory devices, a plurality of microfluidic channels enables to store more information.

In embodiments, each space between adjacent electrodes of the array has an extent measured along the length of the microfluidic channel of from 1 nm to 10 nm. Herein, each space between adjacent electrodes typically comprises an electrically insulating material. In embodiments, the electrodes are separated from each other by an electrical insulator, such as an oxide, e.g., SiO₂. This is advantageous because stacks comprising alternating layers of polycrystalline silicon and an oxide are easy to manufacture using existing (industrial) setups. For example, such stacks may be made using techniques and apparatus used at present in the manufacturing of flash, e.g., NAND, memory devices.

In embodiments, the array of electrodes has an extent measured along the length of the microfluidic channel of at least 70%, such as at least 90%, of the length of the microfluidic channel. This is advantageous as this permits achieving a fast translocation of a charged particle over a large part of the microfluidic channel. The length of the microfluidic channel is measured from the first end to the second end. For instance, it is measured from the inlet to the outlet or, if no outlet is present, from the inlet to the end of the microfluidic channel.

In embodiments, the microfluidic device further comprises a fluid comprising at least one charged particle of a first species. The fluid is typically a liquid. The fluid may be any fluid suitable for dispersing the at least one charged particle, e.g., organic solvents or water, preferably water. Herein, the fluid may comprise dispersing agents suitable for dispersing the at least one charged particle.

When a fluid is present, at least part of the fluid is comprised in the microfluidic channel. If a reservoir and a fluid are present (see infra), a part of the fluid is present in the microfluidic channel and another part of the fluid is comprised in the reservoir. Typically, more than one charged particle of the first species are present in the fluid. In embodiments, a plurality of charged particle species are present in the fluid. When this is the case, typically, more than one charged particle of each species is present in the fluid.

In the context of the present invention, only charged particles having a mean width of at least 0.5 nm, preferably at least 1 nm, are considered as a charged particle of a first or further species. Preferably, the charged particles are charged nanoparticles, having a diameter of from 1 nm to 100 nm. As used herein and unless provided otherwise, when reference is made to a charged particle, a charged particle of a first or further species is meant, i.e., a charged particle having a mean width of at least 0.5 nm, preferably at least 1 nm.

In embodiments, each species of charged particles of a first or further species present in the fluid has a mean width of at most 10 nm. As used herein, the width is the smallest dimension of the particle and the mean width is the sum of the width of all particles of one species present in the fluid, divided by the number of particles of said species in the fluid. it is advantageous to have the widest species of charged particles present in the fluid that has a smaller mean width than twice the mean width of the narrowest species of charged particles present in the fluid. Each species of charged particle of a first or further species present in the fluid may be independently selected from any type of charged particles, such as charged nano-objects (e.g., charged nanoparticles), and charged molecules. Charged nano-objects possess one or more nanoscale dimensions while charged nanoparticles are nano-object with three nanoscale dimensions. Nanoscale dimensions are dimensions measuring at most 100 nm, and typically at least 1 nm. In embodiments, each species of particle present in the fluid may be independently selected from Janus particles, homogeneous particles, and particles comprising a core and a shell wherein a material of the core is different from a material of the shell (i.e., core-shell particles). Core-shell particles are for instance described in KIM, Daihyun; SONKER, Mukul; ROS, Alexandra. Dielectrophoresis: From molecular to micrometer-scale analytes. Analytical chemistry, 2018, 91.1: 277-295.

In embodiments, one, more than one, or all of the species of charged particle present in the fluid may be spheroid or spherical. However, the invention is not limited thereto, and one, more than one, or all species of charged particle present in the fluid may have an irregular shape. In embodiments, all species of charged particle present in the fluid have the same charge sign. In preferred embodiments, a charge of the particles of the first species has a same sign as a charge of the particles of a second species. This is advantageous because aggregation of the first and second particles may thereby be prevented by repulsion between the particles. More generally, all species of charged particle present in the fluid preferably have a charge having the same sign. In embodiments, a magnitude of the charge of the first particles is the same as a magnitude of the charge of the second particles. This is advantageous because the first actuator may induce a similar translocation (similar with respect to, e.g., direction and speed) for all charged particles, e.g. for each of the first species of particles and of the second species of particles. More generally, all species of charged particle present in the fluid preferably have a charge having the same sign and same magnitude.

In embodiments, the different species of charged particles differ with respect to at least one of the following features: material composition; dielectric coefficient; shape; or size. In embodiments, each species of charged particle comprises or consists of a metal, a semiconductor, or a dielectric material. In embodiments, each species of charged particles comprise or consist of organic molecules, e.g., biopolymers such as proteins or nucleic acid particles (e.g. virus or virus parts), or they could be inorganic particles coated with organic molecules.

In embodiments, particles of a first species may have a dielectric constant that is lower than the dielectric constant of the fluid, and particles of a second species may have a dielectric constant that is higher than the dielectric constant of the fluid.

In embodiments, the array of electrodes comprises at least two, e.g., consists of two, series of regularly spaced electrodes. In embodiments, the array may consist of electrodes of the first series alternating with electrodes of the second series. In these embodiments, the two series of electrodes may be interdigitated. In embodiments, the actuator may be configured in such a way that, in operation and within each series, the cyclically changing voltage of each electrode is in phase. In preferred embodiments, wherein the array of electrodes consists of regularly spaced electrodes of the first series alternating with regularly spaced electrodes of the second series (e.g. two interdigitated series of regularly spaced electrodes), the actuator is configured in such a way that, in operation, the cyclically changing voltages of every other electrode along the array are in phase. In embodiments, wherein the array of electrodes consists of regularly spaced electrodes of the first series alternating with regularly spaced electrodes of the second series, the actuator may be configured in such a way that, in operation, the cyclically changing voltages of adjacent electrodes are out of phase by half of a period.

However, the invention is not limited to an array of electrodes consisting of regularly spaced electrodes of the first series alternating with regularly spaced electrodes of the second series. In an alternative example, the array of electrodes may consist of more than two electrode series, such as three electrode series, each consisting of regularly spaced electrodes, wherein the array comprises a repeating pattern of three electrodes belonging to different series, wherein the actuator is configured in such a way that, in operation, adjacent electrodes of the array are out of phase by a third of the period. In general, the array of electrodes may consist of n series of regularly spaced electrodes, wherein the array comprises a repeating pattern of n electrodes belonging to different series, wherein the actuator is configured in such a way that, in operation, adjacent electrodes of the array are out of phase by 1/n of the period.

As indicated above, the array of electrodes may consist of two series of electrodes. It is an advantage of these embodiments that the first actuator may continue and/or accelerate the translocation of charged particles in any of two directions within the microfluidic channel. The first direction is from the first end (e.g., an inlet) to the second end (e.g. an outlet or a closed-end) of the microfluidic channel. The second direction is from the second end to the first end of the microfluidic channel. In that case, when the first actuator operates on a charged particle which is at rest (and if we ignore Brownian motion), the charged particle can be moved in any of both directions, depending on where the electrodes surrounding the charged particle are in their voltage change cycle. When the first actuator operates on a charged particle which is already in motion, the first actuator has globally the effect of continuing and/or accelerating this movement while conserving the direction of that movement. Indeed, even in cases where the electrodes surrounding the charged particle are in a place of their voltage change cycle that creates a force opposing the movement of the charged particle, the inertia of the particle will typically allow the particle to maintain the direction of its initial movement until the electrodes surrounding the charged particle are in a place of their voltage change cycle that creates a force enhancing the movement of the charged particle. The initial movement of the particle can, for instance, be due to the first actuator acting on the particle at rest (see above) or can be due to a second or a third actuator (see below). In these embodiments wherein the array consists of two series of electrodes, preferably, the microfluidic device comprises the second or the third actuator, more preferably at least the second actuator. A same translocation speed may be achieved in the direction from the first end to the second end and in the direction from the second end to the first end. In embodiments wherein the array of electrodes comprises more than two series of electrodes, the potential wave may be limited to propagation either in a direction from the first end to the second end, or in a direction from the second end to the first end. In that case, the charged particle may propagate in the same direction as the potential wave, so that the translocation of the charged particle may not depend on its initial movement or on a direction induced by, e.g., the second or third actuator.

In preferred embodiments, the first actuator may be configured in such a way that, in operation, each electrode of the array sees its voltage changing cyclically within a range of voltages having a minimum and a maximum, wherein the minimum takes a same first voltage value for each electrode of the array (e.g., 0 V), and the maximum takes a same second voltage value (e.g., 5 V) for each electrode of the array. In embodiments, the first actuator may be configured in such a way that, in operation, each electrode of the array sees its voltage changing cyclically within a range of voltages having a minimum and a maximum separated by a voltage of from 1 to 10 V. In embodiments, the first actuator may be configured in such a way that, in operation, the cyclically changing voltage of each electrode has a same minimum equal to 0 V with respect to a ground potential of the microfluidic device. Herein, the voltage may be in presence of a fluid in the microfluidic channel. In embodiments, the first actuator may be configured in such a way that, in operation, each electrode of the array sees its voltage changing cyclically between only two voltage values being a minimum and a maximum voltage value, e.g., the cyclically changing voltage may be a square wave voltage. In embodiments where the first actuator comprises an array consisting of n series of electrodes, the first actuator may be configured in such a way that, in operation, the cyclically changing voltage of each electrode at a position p in the array is at its maximum when the cyclically changing voltage of electrodes at a position from p-n+1 to p-1 are at their minimum. As such, in embodiments wherein adjacent electrodes of the array are out of phase by 1/n of the period, the first actuator may be configured in such a way that, in operation, e.g., in a first mode of operation, when in a first time interval, each electrode at a position p in the array is at its maximum, in a second, subsequent, time interval, preferably contiguous to the first time interval, each electrode at a position p+1 is at its maximum. It is an advantage of these embodiments that a pulse wave may be generated that propagates in a direction between an inlet and an outlet. For example, the pulse wave may propagate either from the inlet to the outlet of from the outlet to the inlet. Thereby, the charged particle may be induced to move in said direction, even in absence of a further actuator. In embodiments, the first actuator may be configured to be switchable between the first mode of operation a second mode of operation, wherein, in the second mode, when in a first time interval, each electrode at a position p in the array is at its maximum, in a second, subsequent, time interval, preferably contiguous to the first time interval, each electrode at a position p-1 is at its maximum. In these embodiments, preferably, n is at least 3. It is an advantage of these embodiments that the pulse wave may be switched between a direction of propagation, for example, in a first mode, from the inlet to the outlet, and in a second mode, from the outlet to the inlet. It is an advantage of these embodiments that no further actuator may be required to determine a movement direction of a charged particle in the microfluidic channel.

In embodiments wherein the array consists of two series of electrodes, the first actuator may be configured in such a way that, in operation, each electrode of the array sees its voltage at the maximum longer than at the minimum. It is an advantage of embodiments of the present invention that fast translocation of a charged particle may be achieved with a simple circuitry. It is a further advantage of embodiments of the present invention that the simple circuitry may result in a limited density loss due to the presence of the first actuator. Herein, the density may be defined as microfluidic channel volume divided by microfluidic device volume.

In embodiments, the first actuator may be configured in such a way that, in operation, a duration of each voltage cycle period is from 1 ns to 10 ns. The duration of the period may be selected depending on the wanted speed of translocation. The first actuator may be configured in such a way that, in operation, the duration of the period of each electrode of the array is short enough so that a moment of inertia of the charged particle does not drop to zero or change sign between subsequent periods. Longer periods allow the charged particle to translocate from an initial electrode to an adjacent electrode faster as long as the moment of inertia of the charged particle does not drop to zero or change sign. Thereby, the charged particle may arrive at the adjacent electrode when a further translocation is induced from the adjacent electrode to a further adjacent electrode, at a different side of the adjacent electrode than the initial electrode. The duration of the period may depend on, at least, a mass, a charge, a shape, and a size of the charged particle. A voltage range of the potential wave, e.g., the voltage range between the minimum voltage and the maximum voltage, may depend on a field distribution in the microfluidic channel, which may depend on a geometry, such as a shape and dimensions, of the microfluidic channel. The duration and the voltage range that are preferred for a particular geometry and a particular charged particle, may be determined using microfluidic models well known to the person skilled in the art. In embodiments, the cyclically changing voltages of adjacent electrodes being out of phase means that the voltages of adjacent electrodes do not simultaneously reach a maximum, or reach a minimum. For example, voltages applied to adjacent electrodes may be temporally shifted, with respect to each other. In embodiments, the first actuator may be configured in such a way that, in operation, the cyclically changing voltages of adjacent electrodes are out of phase by a time equal to from 1% to 99% of the period, such as from 10% to 90% of the period, preferably from 20% to 80% of the period, more preferably from 30% to 70%, yet more preferably from 40% to 60% of the period. In embodiments, the first actuator may be configured in such a way that, in operation, when the array consists of n series of electrodes, the cyclically changing voltages of adjacent electrodes are out of phase by a time equal to preferably from 2%/n to 198%/n of the period, preferably from 10%/n to 190%/n of the period, more preferably from 30%/n to 170%/n of the period, yet more preferably from 50%/n to 150%/n of the period, yet more preferably from 80%/n to 120%/n of the period, yet more preferably from 90%/n to 110%/n of the period, and most preferably 100%/n of the period.

In embodiments, the microfluidic device comprises a second actuator, different from the first actuator, comprising a first electrode at a first end of the microfluidic channel, and a second electrode at a second end of the microfluidic channel, the second actuator being adapted for generating in operation a constant DC field between the first and the second electrodes, the first actuator being situated between the first electrode and the second electrode of the second actuator. This is advantageous because the second actuator may induce a movement of a charged particle, when present, in the microfluidic channel, in addition to the translocation induced by the first actuator. This is advantageous because it eases the selection of the direction of translocation of the charged particle.

In embodiments, the microfluidic device comprises a reservoir for containing a fluid comprising at least one charged particle, the reservoir being fluidically coupled to the microfluidic channel, and a third actuator adapted for inducing a movement of the at least one charged particle between the reservoir and the microfluidic channel by electro-osmosis or dielectrophoresis. In embodiments, the dimensions of the reservoir are such that charged particles present in the reservoir can move past each other in the reservoir. In embodiments, dimensions of the reservoir in at least two perpendicular directions are at least two times as large, preferably at least ten times as large, as a width of the wider charged particle present in the fluid. Thereby, the reservoir is sufficiently large for charged particles to move past each other in the reservoir.

In embodiments, the third actuator is configured to induce the movement of the at least one charged particle between the reservoir and the microfluidic channel by dielectrophoresis. In embodiments, the third actuator comprises a first electrode and a second electrode, wherein the third actuator is configured for generating an alternating current (AC) electric field between the first and second electrode. Preferably, the microfluidic channel and the reservoir are located between the first and second electrodes. Typically, the first electrode faces the first end of the channel and the second electrode faces the second end of the channel. Preferably, a direction of the AC electric field between the first and second electrodes is at an angle of at most 30°, preferably at most 10°, with respect to a longitudinal axis of the microfluidic channel. Preferably, a direction of the AC electric field between the first and second electrodes is parallel to a longitudinal axis of the microfluidic channel. In embodiments, the third actuator may be configured to generate a non-uniform electric field. For example, the electrodes may differ by size or shape. Typically, the dielectrophoretic force exerted on the at least one charged particle depends on the dielectric properties of the particle, relative to dielectric properties of an environment of the particle, i.e., a fluid. Furthermore, as dielectric properties may be frequency-dependent, the dielectrophoretic force may depend on a frequency of the applied electric field.

In alternative embodiments, the third actuator is configured to induce the movement of the at least one charged particle between the reservoir and the microfluidic channel by electro-osmosis. In these embodiments, the third actuator may comprise the first and second electrodes. In these embodiments, the inner walls of the channel may have a non-zero zeta potential, that is, a nonzero surface charge. On application of a DC electric field by the third actuator, ions in the fluid may start moving in a first direction of the electric field, thereby generating a flow of the fluid in the proximity of the inner wall in the first direction. The flow of the fluid may drag proximate charged particles in the first direction, thereby inducing the movement of the charged particles.

In embodiments, the microfluidic device is a memory device. The memory device comprises a fluid comprising at least one charged particle of each of a plurality of species. Typically, the fluid comprises at least one charged particle of a first species and at least one charged particle of a second species. The present invention is particularly useful when implemented as a memory device because it increases the speed of writing and of reading of the sequence of particles in the channel encoding the information in the memory.

The memory device further comprises: c. a writing element for arranging in a sequence the charged particles, thereby yielding a sequence of charged particles in the microfluidic channel, and wherein said arranging of the charged particles comprises arranging the charged particles of the first and second species in a particular order, wherein the channel is adapted to preserve the sequence of the charged particles, and e. a reading element for detecting the sequence of the charged particles in the microfluidic channel. The invention is, however, not limited to memory devices. That is, the microfluidic device may be any type of device requiring translocation of charged particles through a microfluidic channel.

In embodiments wherein the microfluidic device is a memory device, the sequence of particles in the channel may correspond to stored information, i.e., memory data. For instance, in the context of a binary numeral system, the particles of the first species may correspond to "ones", and the particles of the second species may correspond to "zeros". The sequence of particles of the first and second species in the channel may thereby correspond to a sequence of "zeros" and "ones". As such, the writing element may, by arranging in the sequence the particles in the microfluidic channel, store information in the microfluidic channel. Accordingly, the reading element may, by detecting the sequence of the particles in the microfluidic channel, read the information stored in the microfluidic channel.

In embodiments wherein the device is a memory device, the microfluidic channel has a width that is smaller than twice the width of the narrowest of the charged particles but that is larger than the width of the widest of the charged particles. For this reason, it is advantageous to have the widest of the charged particles that is smaller than twice the width of the narrowest of the charged particles. Such a width for the microfluidic channel is advantageous as it permits that a sequence of charged particles in the microfluidic channel be retained over time. Preferably, the width of the microfluidic channel is constant along at least 60% of its length, preferably at least 80% of its length, more preferably at least 90% of its length. In embodiments, the channel may present a section which width is smaller than the narrower of the charged particle. This is especially useful for memory devices when both the first and second end of the channel is open to a reservoir as it prevents the beginning of the charged particle sequence or even the complete charged particle sequence from being discharged in the second reservoir. This section is typically closer to the second end of the channel than to the first end. More typically, this section is present at the second end of the channel.

In embodiments where the charged particles all have charges of the same sign, the microfluidic channel may comprise charged inner surfaces, the charge of the inner surfaces having a same sign as the charge of the particles.

In embodiments comprising the third actuator, the third actuator is configured to generate an inhomogeneous field that may have a highest field at one electrode, and a lowest field at another electrode, and the charged particles may be selected in such a way that the highest field attracts a first species of charged particles while repelling a second species of charged particles. For instance, particles of a first species may have a dielectric constant that is lower than the dielectric constant of the fluid, and particles of a second species may have a dielectric constant that is higher than the dielectric constant of the fluid.

This is advantageous because it allows the third actuator to selectively induce a movement of charged particles of a first species in a first direction, and induce a movement of a second species of particles in a second direction.

In embodiments, the writing element is adapted for ensuring that exactly a single charged particle at a time moves into the channel. In embodiments, wherein the charged particles comprise particles of at least two different species, e.g. charged particles of a first species and charged particles of a second species, the writing element may be adapted to determine which charged particle moves into the channel. In embodiments, the writing element is an electronically controlled gate. In embodiments, the electronically controlled gate is configured so that it can selectively let one species of particle into the channel but not another species of particle. In embodiments, the electronically controlled gate may be configured so that one charged particle at a time may pass through the electronically controlled gate. In embodiments, the electronically controlled gate comprises an electrostatic barrier. In embodiments, the electrostatic barrier is configured to, in a closed state of the electrostatic barrier, block at least one species of particle, such as all species of particles. In embodiments, the electrostatic barrier comprises a barrier electrode and is configured for generating a field for repelling the at least one species of charged particles, such as all species of charged particles. In embodiments, the electrostatic barrier comprises a dielectric material with a nonzero zeta potential that has the same sign than a nonzero zeta potential of the at least one species of charged particles, such as of all species of charged particles. Thereby, the at least one species of charged particles, such as all species of charged particles, is electrostatically repelled by the dielectric material, that is, by the electrostatic barrier. In the closed state of the electrostatic barrier, if the repulsion is sufficiently large e.g. due to a sufficiently large nonzero zeta potential of the dielectric material, the at least one species of charged particles, such as all species of charged particles, is unable to pass the electrostatic barrier. Thereby, in embodiments, in the closed state, the at least one species of charged particles, such as all species of charged particles, that is in the channel cannot leave the channel, and the at least one species of charged particles, such as all species of charged particles, that is not in the channel cannot enter the channel. In embodiments wherein the electrostatic barrier comprises a dielectric material with a nonzero zeta potential that has the same sign as a nonzero zeta potential of the at least one species of charged particles, the electrostatic barrier may further comprise a portal electrode. In these embodiments, the electrostatic barrier may be configured so that, in operation, the portal electrode generates an electric field opposing the electrostatic repulsion generated by the dielectric material. In these embodiments, the electrostatic barrier may be opened by the application of the electric field by the portal electrode. Thereby, in the opened state of the electrostatic barrier, the at least one species of particles may pass the electrostatic barrier, i.e., move between the reservoir and the channel.

In embodiments, the third actuator may be adapted to move a random charged particle from the reservoir to an entrance to the channel, wherein the writing element is adapted to detect which species of charged particle is present at the entrance. In these embodiments, if the writing element detects that the charged particle is required at that time for the sequence in the channel, the writing element may be configured to let the charged particle enter into the channel. In these embodiments, if the writing element detects that the charged particle should not, at that time, form part of the sequence in the channel, the writing element may be configured to move the charged particle away from the channel.

In embodiments, the electronically controlled gate comprises a gate reading element for detecting that a charged particle is present in the electronically controlled gate. In embodiments, the gate reading element is adapted to detect the species of particle that is present in the electronically controlled gate. Advantageously, the detecting of the species of charged particle in the electronically controlled gate may be used to detect writing errors. In embodiments, the gate reading element and the electrostatic barrier may be configured so that the electrostatic barrier is opened when the gate reading element detects that a charged particle to be added to the sequence of particles in the channel is present in the electronically controlled gate. In embodiments, the electrostatic barrier may be configured to subsequently close when the gate reading element detects that the charged particle has moved passed the electrostatic barrier, further into the channel.

In embodiments, the gate reading element is also the reading element, i.e. the element that will read the data stored and retrieved from the channel. In these embodiments, the gate reading element may be an addressing element, as it may perform functions related to addressing data, that is, both writing of data and reading of data and possibly storing of data. Advantageously, in these embodiments, only a single reading element is required in the channel. In embodiments, the gate reading element does not comprise the reading element. Advantageously, in embodiments, although the writing element, and therefore the gate reading element, may be preferably comprised at the entrance (i.e., first end or inlet) of the channel, the reading element may be preferably comprised at a different location in the channel. In embodiments, in particular in embodiments comprising the reservoir, if the reading element is at the entrance of the channel, detecting the sequence of charged particles by the reading element may result in losing the sequence of charged particles, e.g. as the charged particles move from the channel into the reservoir during the detecting of the sequence. In embodiments comprising the reservoir, the reading element may be located at an entrance of the channel, and may be configured to detect the particles moving in and/or out of the channel. In these embodiments, detecting of the sequence of charged particles in the channel comprises moving the particles from the channel to outside of the channel via the reading element. Thereby, the detecting may result in loss of the sequence of particles.

On another hand, if the reading element is not at the entrance of the channel but at a location in the channel situated between the first and the second end of the channel, reading the data stored in the channel can be done without changing the sequence of charged particles in the channel and, hence, without losing the sequence of charged particles. In different embodiments, the reading element is located away from any end of the channel, for instance halfway along the channel.

In embodiments, at least some of the features of the gate reading element may be identical to at least some of the features possible for the reading element. In embodiments, the gate reading element comprises the same features as the reading element. Advantageously, the gate reading element may be used to check that a charged particle of choice is moved into the channel.

In embodiments, the reading element comprises a capacitor or a field-effect transistor, or is configured for detecting a magnetic field. In embodiments wherein the reading element comprises the capacitor, the capacitor may comprise a first capacitor plate and a second capacitor plate. In embodiments, the first plate may be located in the inner wall of the channel on a first side of the channel, and the second plate may be located in an inner wall of the channel on a second side of the channel opposite to the first side of the channel. In alternative embodiments, the capacitor comprises a first capacitor plate in the inner wall of the channel at a first location, and a second capacitor plate in the same inner wall of the channel at a second location. Herein, the first location is closer to an entrance of the channel than the second location. In these embodiments, the capacitance of the capacitor may be different when the first particle is present between the first plate and the second plate than when the second particle is present between the first plate and the second plate. In embodiments wherein the reading element comprises the field-effect transistor, a surface of a gate of the field-effect transistor may be exposed to fluid in the channel. In embodiments, the field-effect transistor is adapted to detect the charge of a particle in the proximity of the gate. In embodiments wherein the particles of a first species have a different charge, e.g., a different magnitude but a same sign, than the charged particles of a second species, the field-effect transistor is suitable to differentiate between the first particles and the second particles.

In embodiments, the electronically controlled gate comprises a gate actuator. In embodiments, the gate actuator is adapted to induce a movement of at least one species of charged particles, such as all charged particles, at least at the entrance of the channel, close to the writing element. In embodiments, the gate actuator may comprise at least a first electrode at the entrance of the channel. In embodiments, the gate actuator may comprise a second electrode. In embodiments, the gate actuator is configured to generate an electric field between the first and second electrodes of the gate actuator. In embodiments, the gate actuator is configured to be able to attract all charged particles or a single species of charged particle. In embodiments, the gate actuator is configured to be able to repel all charged particles or a single species. In embodiments, an electric field may be generated between an electrode of the gate actuator and an electrode of the third actuator to induce a movement of the particles. In these embodiments, the gate actuator and the third actuator may be adapted to induce a movement of at least one species of charged particles, such as of all species of charged particles, such as in the reservoir or in the channel, towards or away from the channel. In embodiments, the gate actuator is adapted to induce the movement by means that are also available for the third actuator, preferably by electro-osmosis and/or dielectrophoresis. Advantageously, in embodiments comprising the reservoir, upon application of an electric field between the first and second electrode of the gate actuator, the gate actuator may be used to attract a single species of charged particle from the reservoir to the entrance of the channel. Advantageously, the gate actuator may be used to repel other species of charged particles than the single species of charged particle. Thereby, the gate actuator may be used to facilitate the arranging in a sequence of the charged particles, by attracting the species of charged particle in the channel where they are required.

In addition, advantageously, the gate actuator may be adapted to induce a movement of a particle within the electronically controlled gate. In embodiments, the gate actuator may be configured to move the particle within the electronically controlled gate from or to the gate reading element. In embodiments, if the electrostatic barrier is opened, the gate actuator may be configured to move the charged particle within the electronically controlled gate through the electrostatic barrier, into the channel. Advantageously, the gate actuator may be used to induce the movement of charged particles in the writing element. However, in embodiments, the gate actuator is not required: the movement of the charged particles in the writing element may also be induced by the third actuator. In embodiments, the gate actuator may comprise the first electrode and the second electrode, wherein the first electrode is closer to an entrance of the channel than the second electrode, and wherein the second electrode is comprised between the first electrode and the electrostatic barrier. In embodiments, the distance between the first electrode and the electrostatic barrier, may be sufficient to comprise a charged particle between them. In embodiments, this distance may be such that only one charged particle may be present between them. In embodiments, the gate actuator is configured to, if the single charged particle is present in the writing element, generate an electric field so that the first electrode repels all charged particles, whereas the second electrode attracts all charged particles. In embodiments, the size of the second electrode may be such that only the single charged particle remains in the writing element. Alternatively, in embodiments, the writing element may comprise a waiting channel between the gate actuator and the electrostatic barrier, the waiting channel having a length suitable for comprising only a single charged particle. In embodiments, the gate actuator may be configured to, if a single charged particle is present in the waiting channel, generate an electric field to repel all charged particles. Thereby, all other particles than the single charged particle may be induced to move away from the writing element, so that only the single charged particle is present in the writing element, i.e. in the waiting channel. In embodiments, the gate actuator is, if the electrostatic barrier is opened, configured to generate an electric field for repelling the single charged particle. Thereby, the single charged particle may be induced to move past the electrostatic barrier, further into the channel.

Any features of any embodiment of the first aspect may be independently as correspondingly described for any embodiment of the second aspect of the present invention.

In a second aspect, the present invention relates to a method for translocating a charged particle along a microfluidic channel in a microfluidic device according to embodiments of the first aspect, comprising providing a device according to embodiments of the first aspect comprising a fluid comprising at least one charged particle, wherein at least part of the fluid is comprised in the microfluidic channel, and generating a potential wave along the microfluidic channel. The potential wave has the effect of putting in motion or accelerating the motion of charged particles present in the channel. Preferably, in the second aspect, the present invention relates to a method for translocating a charged particle along a microfluidic channel in a microfluidic device according to embodiments of the first aspect, comprising providing a device according to embodiments of the first aspect comprising a fluid comprising at least one charged particle, wherein at least part of the fluid is comprised in the microfluidic channel, and applying a cyclically changing voltage to each electrode of the array according to a period multiplied by a natural number, wherein for at least one electrode (31, 32) the natural number equals 1 (e.g. according to a same period) and in such a way that the cyclically changing voltage of adjacent electrodes are out of phase.

Any features of any embodiment of the second aspect may be independently as correspondingly described for any embodiment of the first aspect of the present invention.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

### EXAMPLE: Memory device

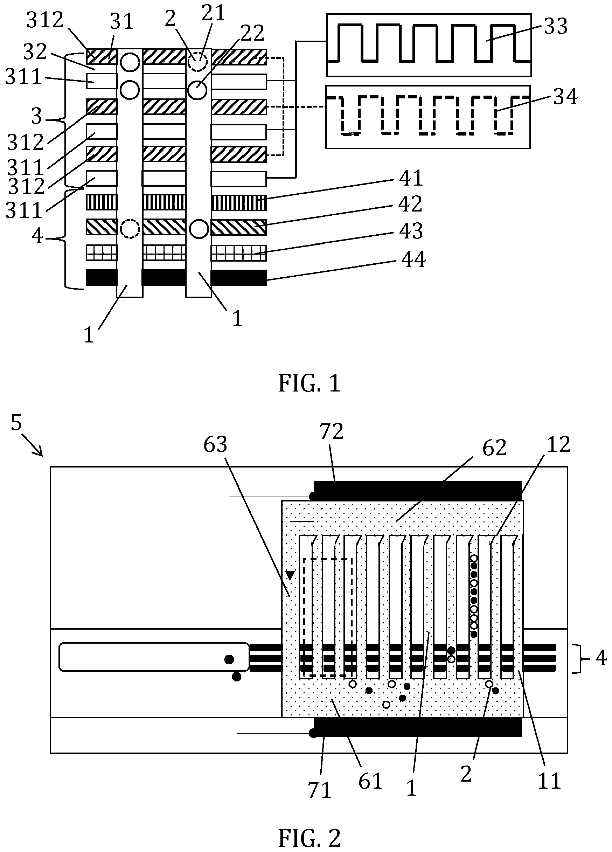

FIG. 1 is a schematic cross-section of part of a memory device according to embodiments of the present invention. Two microfluidic channels 1 of the microfluidic device are depicted in this example but the device can comprise any number of microfluidic channels. Each microfluidic channel 1 comprises a fluid with a plurality of charged particles 2. In this example, the charged particles 2 comprise first species 21 and second species 22 of charged particles. In the case of a memory device, two or more different species of charged particles can be used. The sign and magnitude of the charges of each of the first 21 and second species of particles 22 are the same.

A first actuator comprises an array of electrodes 3 along the microfluidic channel 1. In this example, a wall of the microfluidic channel 1 is formed from a stack of alternating conductive 31 (i.e., the electrodes of the array) and electrically insulating layers 32. In this example, the first actuator comprises a first set of electrodes 311 and a second set of electrodes 312 within the array 3. More sets of electrodes are also possible. Herein, electrodes of the first set 311 alternate with electrodes of the second set 312. The first actuator is configured for applying first cyclically changing voltages 33 to the first set of electrodes 311 and second cyclically changing voltages 34 to the second set of electrodes 312. The first 33 and second cyclically changing voltages 34 are applied according to a same period. However, the first cyclically changing voltages 33 and the second cyclically changing voltages 34 are out of phase. In this example, the first 33 and second cyclically changing voltages 34 are out of phase by half of the period. In this example, each of the cyclically changing voltages 33 and 34 cycles between only two voltage values, i.e., a minimum and a maximum voltage value. The minimum and maximum are the same for each of the electrodes 31 of the array 3.

In this example, the charged particles are cyclically electrophoretically attracted, thereby translocated, during each cycle, first, towards electrodes of the first set of electrodes 311. Next, the charged particles are attracted, thereby translocated, towards electrodes of the second set of electrodes 312. In principle, when a particular charged particle is at an electrode of the first set of electrodes 311, the particular charged particle may become attracted towards the two electrodes of the second set of electrodes 312 adjacent to the electrode. However, the particular charged particle may have a moment of inertia remaining from a previous cycle of the cyclically changing voltage. Thereby, the particular charged particle may preferentially translocate towards one of the two adjacent electrodes 312, so that the translocation may be always in a same direction. Alternatively, a second actuator (not shown) may be comprised in the microfluidic channel 1. The second actuator may comprise a first electrode at a first end of the microfluidic channel 1, and a second electrode at a second end of the microfluidic channel 1. The second actuator may be adapted for generating a constant DC field between the first and the second electrodes. As such, the second actuator may, by electrophoresis, determine a direction for translocation of the charged particles 2 within each microfluidic channel 1. Still alternatively, a third actuator, adapted for inducing a movement of the charged particles 2 by electro-osmosis or dielectrophoresis, may induce a preferred direction for translocation.

Reference is made to FIG. 2. In this example, the microfluidic device is a memory device 5, although the invention is not limited thereto. The rectangle defined by the dashed lines corresponds the part of the memory device 5 shown, enlarged, in FIG. 1. In this example, the microfluidic device, i.e., the memory device 5, comprises a reservoir 61, comprising part of the fluid and a large amount of two species of charged particles 2. The reservoir 61 is fluidically coupled to a first end 11 of each of the microfluidic channels 1 of the memory device 5. The memory device 5 further comprises a third actuator adapted for inducing a movement of the charged particles 2 between the reservoir 61 and the microfluidic channel 1 by electro-osmosis or dielectrophoresis. Herein, the third actuator comprises a first electrode 71 and a second electrode 72. For example, an AC voltage may be applied between the first 71 and second electrode 72, thereby dielectrophoretically inducing a movement of the charged particles 2. Alternatively, a DC voltage may be applied to the first 71 and second electrode 72, thereby electroosmotically inducing a movement of the charged particles 2. Herein, the electroosmosis mainly occurs within the fluidic channels 1 due to their small diameter compared to that of the reservoir 61.

Each fluidic channel 1 comprises a constricted opening at a second end 12 of the fluidic channel 1, fluidically coupled to a further reservoir 62. The constricted opening may prevent movement of the charged particles 2 through the second end 12. However, the fluid may pass through the second end 12 into the further reservoir 62, thereby preventing pressure build-up at the second end 12. Pressure build-up may occur, for example, due to electroosmosis from the first end 11 to the second end 12, or due to the charged particles 2 moving through the fluidic channel 1 towards the second end 12, accompanied by movement of the fluid towards the second end 12. The pressure build-up could hamper or prevent movement of the charged particles 2 in the fluidic channel 1. A broad passage 63 enable movement of fluid may enable movement between the reservoir 61 and further reservoir 62. This may prevent pressure from building up in the reservoir 61 and further reservoir 62.

The memory device 5 comprises, at the first end 11 of each fluidic microchannel 1, a writing element for arranging in a sequence the charged particles 2. Thereby, a sequence of charged particles 2 in the microfluidic channel 1 may be obtained. Said arranging of the charged particles comprises arranging the first species 21 and second species of charged particles 22 in a particular order, wherein the channel 1 is adapted to preserve the sequence of the charged particles 2. The memory device 5 comprises, at the first end 11 of each fluidic microchannel 1, a reading element for detecting the sequence of the charged particles in the microfluidic channel. The reading and writing elements are formed by a series of electrodes 4 at the entrance of each of the microfluidic channels 1.

Reference is, again, made to FIG. 1, which comprises an enlarged side view of the series of elements 4. In this example, the series of elements 4 comprises an electrostatic barrier 41, which may electrostatically repel the charged particles or allow the charged particles to pass. Instead of the electrostatic barrier 41, however, an electrodeposition gate could be used, configured for reversibly depositing material. Thereby, material may be deposited on the electrodeposition gate, e.g., by reduction or oxidation of ions from the fluid, hindering passage of the charged particles 2 past the gate.

The series of elements 4 further comprises a reading element 42, e.g., a capacitor or field-effect transistor. In this example, the series of elements further comprises awriting element comprises a gate actuator comprising a first gate electrode 44 and a second gate electrode 43. The first gate electrode 44 may be configured for selectively attracting a charged particle 21 or 22. For example, during a write operation, an AC electric field may be generated by the first gate electrode 44 of each channel so as to selectively dielectrophoretically attract only first species of charged particles 21 or only second species of charged particles 22. Herein, for each channel, a different species of particle 21 or 22 may be attracted. The AC electric field may for instance be generated between the first gate electrode 44 of and the first electrode 71 of the third actuator. Next, an AC signal for attracting all charged particles 21 and 22 may be applied to the second gate electrode 43. At the same time, the first gate electrode 44 may generate an AC signal for repelling all charged particles 21 and 22. The repelling will cause the charged particle 21 or 22 in each microfluidic channel 1 to move towards the second gate electrode 43 of the channel 1, while any other particles 21 and 22 that may have only partially entered or come close to the channel 11 are repelled into the reservoir 61. Thereby, only a single charged particle 21 or 22 is able to enter each channel 1. Herein, the reading element 43 may check whether the charged particle 21 or 22 is wanted to enter the channel 1, i.e., required in the sequence in the channel 1. If the charged particle 21 or 22 is wanted, the electrostatic barrier 41 may be opened to allow the charged particle to enter the channel. If not, the electrostatic barrier 41 may, for example, remain closed, and the charged particle 21 or 22 may be removed from the channel entrance 11.

Once the charged particle 21 or 22 enters the channel 1, the first actuator 2 induces a translocation of the charged particles 21 and 22 through the channel 1, from the first end 11 to the second end 12. The write operation may be repeated a number of times so as to obtain a sequence of charged particles 21 and 22 in each channel 1.

During an operation of reading the sequence in each channel 1, the charged particles may be induced to move, e.g., translocate, through the opening at the first end 11 of the channel 1. For this, the electrostatic barrier 41 is first opened. Next, the first actuator 3, possibly in combination with the second actuator and/or third actuator, may enable fast translocation of the charged particles 21 and 22 past the reading element 42. The reading element 42 may detect the sequence of the charged particles 21 and 22 in each of the channels 1. In this example, the read operation is destructive, since it requires all charged particles 21 and 22 to pass by the reading element 42, and therefore flow out of the channels 1 and into the reservoir 61. Therefore, in this example, a re-write operation may be required after the read operation.

In this example, a very specific memory device has been described. However, it will be clear to the skilled person that the memory device may be any memory device comprising charged particles, e.g., any type of colloidal nanofluidic memory device. For example, the specific reading and writing elements, and their operation, are an example of how reading and writing in such memory device may possibly be performed. However, the skilled person will realize that very different reading and writing mechanisms may be envisaged without going beyond the scope of the present invention.

It is to be understood that although preferred embodiments, specific constructions, and configurations, as well as materials, have been discussed herein for devices according to the present invention, various changes or modifications in form and detail may be made without departing from the scope of this invention. Steps may be added or deleted to methods described within the scope of the present invention.

## Claims

1. A microfluidic device comprising:
a microfluidic channel (1), and
a first actuator comprising an array of electrodes (3) along the microfluidic channel (1),
wherein the first actuator is configured to generate a potential wave along the microfluidic channel.

2. The microfluidic device according to claim 1 wherein the first actuator is configured in such a way that, in operation:
each electrode (31, 32) of the array (3) sees its voltage (33, 34) changing cyclically according to a period multiplied by a natural number, wherein for at least one electrode (31, 32) the natural number equals 1, and
the cyclically changing voltages (33, 34) of adjacent electrodes (31, 32) are out of phase.

3. The microfluidic device according to claim 2, wherein the cyclically changing voltages (33, 34) of every other electrode (31, 32) along the array (3) are in phase.

4. The microfluidic device according to any one of the preceding claims, wherein each electrode (31, 32) of the array (3) sees its voltage (33, 34) changing cyclically within a range of voltages having a minimum and a maximum separated by a voltage of from 1 to 10V.

5. The microfluidic device according to any one of the preceding claims, wherein each electrode (31, 32) of the array (3) sees its voltage (33, 34) changing cyclically within a range of voltages having a minimum and a maximum, wherein the minimum take the same voltage value for each electrode (31, 32) of the array (3), and the maximum take the same voltage value for each electrode (31, 32) of the array (3).

6. The microfluidic device according to any one of the preceding claims, wherein the cyclically changing voltage (33, 34) of each electrode (31, 32) is at its maximum when the cyclically changing voltage (33, 34) of each adjacent electrode (31, 32) is at its minimum.

7. The microfluidic device according to any of the previous claims, wherein a duration of each period is from 1 ns to 10 ns.

8. The microfluidic device according to any one of the previous claims, wherein each electrode (31, 32) of the array (3) sees its voltage (33, 34) changing cyclically between only two voltage values being a minimum and a maximum voltage values.

9. The microfluidic device according to any one of the previous claims, wherein the cyclically changing voltage (33, 34) of each electrode (31, 32) has a same minimum equal to 0 V.

10. The microfluidic device according to any one of the previous claims, comprising a second actuator, different from the first actuator, comprising a first electrode at a first end (11) of the microfluidic channel (1), and a second electrode at a second end (12) of the microfluidic channel (1), the second actuator being adapted for generating a constant DC field between the first and the second electrodes, the first actuator being situated between the first electrode and the second electrode of the second actuator.

11. The microfluidic device according to any of the previous claims, wherein the array of electrodes (3) has an extent measured along the length of the microfluidic channel (1) of at least 70%, such as at least 90%, of the length of the microfluidic channel (1).

12. The microfluidic device according to any of the previous claims, comprising a reservoir (71) for containing a fluid comprising at least one charged particle (2), the reservoir (71) being fluidically coupled to the microfluidic channel (1), and a third actuator adapted for inducing a movement of the at least one charged particle (2) between the reservoir (71) and the microfluidic channel (1) by electro-osmosis or dielectrophoresis.

13. The microfluidic device according to any of the previous claims, further comprising a fluid comprising at least one charged particle (2), wherein at least part of the fluid is comprised in the microfluidic channel (1), and if a reservoir (71) is present, another part of the fluid is comprised in the reservoir (71).

14. The microfluidic device according to claim 12 or claim 13, being a memory device (5), wherein the at least one charged particle (2) are a plurality of particles comprising a first particle species (21) and second particles species (22), the device further comprising:
c. a writing element (4) for arranging in a sequence the charged particles (2), thereby yielding a sequence of particles (2) in the microfluidic channel (1), and wherein said arranging of the charged particles (2) comprises arranging the first (21) and second species of charged particles (22) in a particular order, wherein the channel (1) is adapted to preserve the sequence of the charged particles (2), and
e. a reading element (42) for detecting the sequence of the charged particles (2) in the microfluidic channel (1).

15. A method for translocating a charged particle along a microfluidic channel (1) in a microfluidic device according to any one of claims 1 to 14, comprising:
- providing a device according to any one of claims 1 to 14 comprising a fluid comprising at least one charged particle (2), wherein at least part of the fluid is comprised in the microfluidic channel (1), and
- generating a potential wave along the microfluidic channel.
